# EUROPÄISCHE PATENTSCHRIFT

(11) **EP 0 346 411 B1**
(45) Veröffentlichungstag und Bekanntmachung des Hinweises auf die Patenterteilung: **11.08.1993**
(21) Anmeldenummer: 88910023.6
(22) Anmeldetag: 18.11.1988
(51) Int. Cl.: H01L 39/20, H01L 39/12, H01L 39/10

(54) **HOCHSTROMSCHALTER**
HIGH-CURRENT SWITCH
COMMUTATEUR DE COURANT DE HAUTE INTENSITE

(30) Priorität: 20.11.1987 DE 3739412
(43) Veröffentlichungstag der Anmeldung: 20.12.1989
(73) Patentinhaber: HEIDELBERG MOTOR GESELLSCHAFT FUER ENERGIEKONVERTER MBH, D-82319 Starnberg (DE)
(72) Erfinder: EHRHART, Peter, D-8000 München 70 (DE); GRÜNDEL, Andreas, D-8000 München 70 (DE); HEIDELBERG, Götz, D-8136 Starnberg-Percha (DE); WECK, Werner, D-8130 Starnberg (DE)
(74) Vertreter: Klunker . Schmitt-Nilson . Hirsch
(86) Internationale Anmeldenummer: EP8801050
(87) Internationale Veröffentlichungsnummer: WO8905044

(56) Entgegenhaltungen:
- DE-A- 1 564 679
- DE-A- 2 410 148
- DE-C- 665 578
- DE-C- 1 260 047
- FR-A- 2 268 373
- US-A- 3 324 436
- US-A- 3 956 727
- Patent Abstracts of Japan, Band 5, Nr. 70 (E-56)(742) 12. Mai 1981 & JP-A-56 18 482, siehe das ganze Dokument
- Journal of Physics D: Applied Physic, Band 20, Nr. 10, 14. Oktober 1987 (Bristol, GB) M.Wautelet: "The principle of a gate obtained by laser irradiation of a thin superconductor film", Seiten 1318, 1319, siehe den ganzen Artikel

## Beschreibung

Die Erfindung bezieht sich auf die Verwendung eines mit Supraleitmaterial als Schaltmedium aufgebauten Hochstromschalters zur Entnahme von Strompulsen aus einer supraleitenden Speicherspule, wobei der Schalter periodisch vom supraleitenden Zustand in den nichtsupraleitenden Zustand überführt wird und umgekehrt.

Eine derartige Schalterverwendung ist aus dem Dokument FR-A-2 268 373 bekannt. Dort wird der mit Supraleitmaterial aufgebaute Schalter dadurch in den nicht-supraleitenden, geöffneten Zustand überführt, daß man ein genügend starkes Magnetfeld auf ihn zur Einwirkung bringt.

Demgegenüber ist die Verwendung des Hochstromschalters erfindungsgemäß dadurch gekennzeichnet, daß das Überführen in den nicht-supraleitenden Zustand durch einen am Schalter anstehenden, zeitlich ansteigenden Strom oder durch diesen Strom in Kombination mit einer weiteren Einrichtung zum Überführen in den nicht-supraleitenden Zustand erfolgt.

Aus dem Dokument DE-A-24 10 148 ist es zwar bekannt, einen mit Supraleitmaterial aufgebauten Schalter als Strombegrenzungsschalter für Kurzschlußsituationen einzusetzen, wobei der Übergang in den nicht-supraleitenden Zustand durch das Eigenmagnetfeld des Schalters erfolgt.

Bei dieser Schalterverwendung geht es aber nicht um die Entnahme von Strompulsen aus einer supraleitenden Speicherspule und das periodische öffnen und Schließen des Schalters.

Der erfindungsgemäß verwendete Hochstromschalter eröffnet die Möglichkeit, durch selbstgesteuerte Überschreitung eines für das verwendete Supraleitmaterial kritischen Stromwerts das öffnen bzw. Trennen des Schalters auszulösen. Man kann also einen ansteigenden Strom selbsttätig oberhalb eines bestimmten Schwellwerts abschalten. Wenn der Strom anschließend erneut ansteigt, kommt man zu einer periodischen bzw. zyklischen Abschaltung mit dazwischen jeweils wieder zum Schwellwert ansteigender Stromstärke. Dies kann hochfrequent geschehen.

Der erfindungsgemäß verwendete Schalter eignet sich besonders zum Schalten von Gleichströmen hoher Stromstärke, ganz besonders in induktiven Stromkreisen bei hoher Gegenspannung. Der Schalter kann in sehr kurzen Zeiten schalten und insbesondere sehr kurze Schaltzyklen, bestehend aus Einschalten und kurz danach anschließendem Ausschalten, liefern, insbesondere Schaltzyklen kürzer als 10 ms, vorzugsweise kürzer als 5 ms, höchst vorzugsweise kürzer als 1 ms bzw. Schaltfrequenzen in kHz-Bereich. Der Schalter kann mit hoher spezifischer Stromtragfähigkeit und/oder in sich induktivitätsarm gebaut werden.

Der erfindungsgemäß verwendete Schalter eignet sich ganz besonders für Schaltvorgänge, die beim Zuführen von jeweils sehr kurzen, elektrischen Energiepulsen zu einem Verbraucher erforderlich sind. Als ein typisches Beispiel seien Hochtemperatur-Werkstückbearbeitungsmaschinen genannt. Die supraleitende Speicherspule, mit der der Schalter zusammenarbeitet, kann mit Supraleitern sehr kleinen Durchmessers oder sehr kleiner Schichtdicke aufgebaut sein. Der Durchmesser bzw. die Schichtdicke ist vorzugsweise kleiner als 20 µm oder kleiner als 10 µm.

Als weitere Einrichtung, die in Kombination mit dem zeitlich ansteigenden Strom den Übergang vom supraleitenden in den nicht-supraleitenden Zustand bewerkstelligt, eignet sich prinzipiell eine Temperaturänderungseinrichtung, vorzugsweise in Form der Einstrahlung von Wärmeenergie, da Supraleitmaterial bekanntlich oberhalb der sogenannten Sprungtemperatur die Supraleitfähigkeit verliert. Ferner sind als weitere Einrichtung zur Überführung des Supraleitmaterials vom supraleitenden Zustand in den nicht-supraleitenden Zustand die Aufbringung bzw. das Einwirkenlassen eines Magnetfelds, eines Hochfrequenzfelds, eines Laserstrahls, eines Maserstrahls oder eines genügend hohen Stromimpulses auf das Supraleitmaterial bevorzugt. Durch den zusätzlichen Einsatz derartiger Mittel wird die Energie im Supraleitmaterial so stark erhöht, daß dort die Supraleitfähigkeit zusammenbricht. Im Fall der Hochfrequenzeinstrahlung wird ein zusätzlicher Strom im Supraleitmaterial induziert. Hier wird, wie bei der Einleitung eines zusätzlichen Stroms in den Schalter, der Effekt ausgenutzt, daß ein Supraleiter ab einer Schwellen-Stromstärke plötzlich seine Supraleitfähigkeit verliert. Verschiedene Einrichtungen der genannten Art können miteinander kombiniert sein.

Sofern eine vorstehend beschriebene, weitere Einrichtung eingesetzt wird, kehrt das Supraleitmaterial in den supraleitenden Zustand zurück, sobald die Einwirkung der weiteren Einrichtung beendet wird, selbstverständlich unter der Voraussetzung, daß eine Temperatur unterhalb der Sprungtemperatur des verwendeten Supraleitmaterials herrscht.

Es ist günstig, den Schalter nahe bei der Sprungtemperatur des verwendeten Supraleitmaterials zu halten, so daß zum Trennen des Schalters eine möglichst geringe Energiemenge einzubringen ist.

Der technische Aufwand für Bau und Betrieb des Schalters verringert sich, wenn - wie bevorzugt - als Supraleitmaterial ein Hochtemperatur-Supraleitmaterial eingesetzt wird, wiewohl der Einsatz von herkömmlichem Supraleitmaterial ebenfalls mgölich ist. Unter Hochtemperatur-Supraleitmaterialien versteht man solche, die noch bei erheblich höheren Temperaturen, als man es bis vor einiger Zeit für grundsätzlich möglich gehalten hat, supraleitend sind. Als griffige Grenze kann man für diese Materialien eine Sprungtemperatur, also Temperatur des Übergangs vom supraleitenden in den normalleitenden Zustand, von 80 °K angeben. Typisch ist, daß Hochtemperatur-Supraleiter bei einer Temperatur knapp unterhalb des Siedepunktes von flüssigem Stickstoff noch supraleitend sind. Typische Materialien für Hochtemperatur-Supraleiter sind ABa₃CuO₇ (mit A = Y, La, Nd, Sm, Eu, Gd, Ho, Er, Lu) sowie Y_{1,2,}Ba_{0,8}CuO₄. Als weiteres Beispiel sei La_{1,85}Sr_{0,15}CuO₄ erwähnt, das eine Sprungtemperatur von ca 40 °K aufweist und in obiger Definition kein Hochtemperatur-Supraleiter ist. Diese Materialien sind in der Regel sogenannte Schichtleiter oder zweidimensionale Supraleiter. Hochtemperatur-Supraleiter sind an sich bekannt, wie auch herkömmliche Supraleiter, deren Sprungtemperatur im Bereich von einigen Grad Kelvin liegt, wofür konkretere Beispiele, weil allgemein bekannt, nicht angegeben werden müssen.

Das Supraleitmaterial des Schalters kann in Form von aufgedampften oder sonstwie aufgebrachten Dünnschichten vorliegen. Dies führt dazu, daß die beim Schalten des Schalters induzierten Wirbelströme möglichst klein gehalten werden und somit die Schaltverluste minimal sind. Die Schichtdicke der Dünnschicht ist vorzugsweise kleiner als 20 µm, höchst vorzugsweise kleiner als 10 µm.

Da das Supraleitmaterial für den supraleitenden Zustand auf eine Temperatur unterhalb der Sprungtemperatur gebracht bzw. dort gehalten werden muß, ist es günstig, die Träger für die Supraleit-Dünnschicht(en) auf hohe Wärmeleitfähigkeit hin auszulegen. Außer der hierfür sinnvollen geometrischkonstruktiven Auslegung des Schalters kommt insbesondere die Wahl von Materialien mit hoher spezifischer Wärmeleitfähigkeit für den Dünnschichtträger in Betracht.

Man kann die Schichtdicke der Dünnschicht(en) an die gewünschte Flankensteilheit des Schaltvorgangs des Schalters anpassen. Dabei gilt generell die Abhängigkeit, daß kleinere Schichtdicken Schaltvorgänge mit größerer Flankensteilheit erlauben.

Die Erfindung und Ausgestaltungen der Erfindung werden im folgenden anhand schematisiert zeichnerisch dargestellter Ausführungsbeispile noch näher erläutert. Es zeigt:
- Fig. 1: einen Längsschnitt eines Hochstromschalters;
- Fig. 2: einen Querschnitt des Schalters gemäß Fig. 1;
- Fig. 3: eine Seitenansicht des Schalters gemäß Fig. 1, jedoch versehen mit einer Magnetspule;
- Fig. 4: ein Strom-Zeit-Diagramm eines Hochstromschalters, der durch Zusatzstromimpuls geschaltet wird;
- Fig. 5: ein Strom-Zeit-Diagramm eines Hochstromschalters, der mit ansteigendem Strom selbsttätig schaltet.

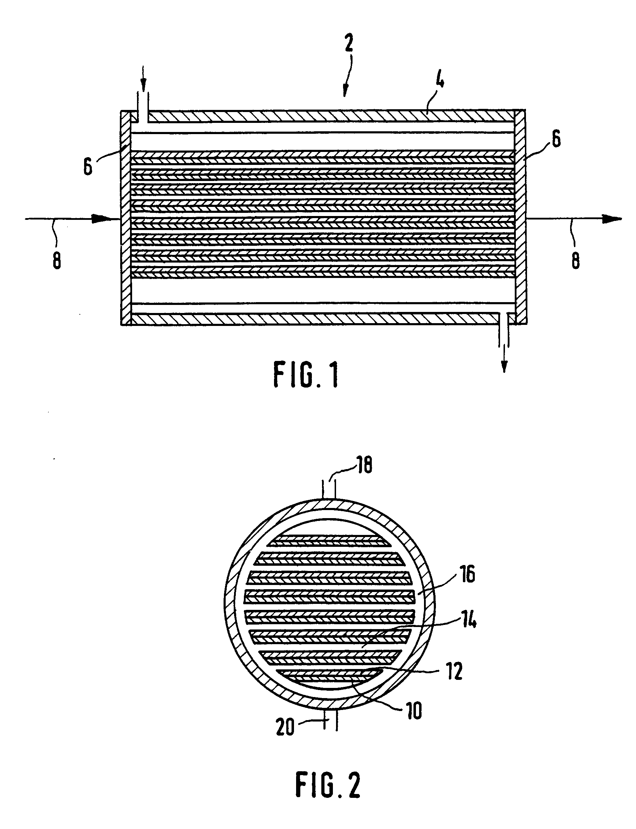

Der in Fig. 1 und 2 dargestellte Hochstromschalter 2 weist ein im wesentlichen zylindrisches Gehäuse 4 mit leitenden Endscheiben 6 auf. Sowohl von der linken Endscheibe 6 als auch von der rechten Endscheibe 6 geht ein Stromleiter 8 ab. Mit dem Schalter 2 kann der Stromfluß zwischen den Enden der beiden Stromleiter 8 entweder geschlossen oder getrennt werden.

Im Inneren des Gehäuses 4 sind stapelartig übereinander acht Anordnungen jeweils aus einem dünnen, plattenartigen, isolierenden Träger 10 und darauf aufgedampft einer sehr dünnen Schicht 12 aus hochtemperatur-supraleitendem Material angeordnet. Die Halterung dieser Anordnungen 10, 12 im Gehäuse 4 ist nicht gesondert zeichnerisch dargestellt. Zwischen zwei benachbarten derartigen Anordnungen 10, 12 befindet sich jeweils ein flacher Kühlmittelraum 14, der beidseits in einen zylinderschichtförmigen Kühlmittelraum 16 ausmündet. Dieser Kühlmittelraum 16 ist oben an eine Kühlmittelzuleitung 18 und unten an eine Kühlmittelableitung 20 angeschlossen. Als Kühlmittel dient flüssiges Helium, oder - im Fall von Hochtemperatur-Supraleitern - flüssiger Stickstoff. Das Kühlmittel wird laufend durch den Schalter 2 hindurchgepumpt, und durch geeignete Kühlmittelleiteinrichtungen ist dafür gesorgt, daß das Kühlmittel ordnungsgemäß durch sämtliche Kühlmittelräume 14, 16 strömt.

Statt die Dünnschichten 12 jeweils auf einen Träger 10 aufzudampfen kann man auch eine andere geeignete Art der Aufbringung des supraleitenden Materials auf geeignete Substrate vorsehen.

Die einzelnen Dünnschichten 12 sind axial an beiden Enden elektrisch leitend mit den Endplatten 6 verbunden. Die einzelnen Dünnschichten 12 sind so dünn, daß möglichst geringe Wirbelströme erzeugt werden. Die einzelnen Dünnschichten 12 sind infolge des vorstehend geschilderten Aufbaus elektrisch voneinander isoliert.

Es versteht sich, daß die Schaltverlustleistung durch das Kühlmedium abgeführt werden muß. Dementsprechend ist die Durchflußmenge des Kühlmediums auf die Größe der Schaltverlustleistung und die Häufigkeit von Schaltvorgängen abgestimmt.

Der entsprechend der Größe des zu schaltenden Stroms erforderliche, elektrische Widerstand bzw. die gewünschte Spannungsfestigkeit des Schalters 2 hängt außer vom spezifischen elektrischen Widerstand des Supraleitmaterials im nicht-supraleitenden Zustand und vom Gesamtquerschnitt des Supraleitmaterials noch von der Länge des Schalters 2 zwischend den Endplatten 6 ab. Diese Länge kann entsprechend den jeweiligen Erfordernissen festgelegt bzw. von Einsatzzweck zu Einsatzzweck variiert werden. Es ist möglich, in einem Schalter mehrere, einzeln kontaktierte Schalterabschnitte hintereinander zu haben und je nach erforderlicher Spannungsfestigkeit die Anzahl tatsächlich benutzter Schalterabschnitte zu variieren.

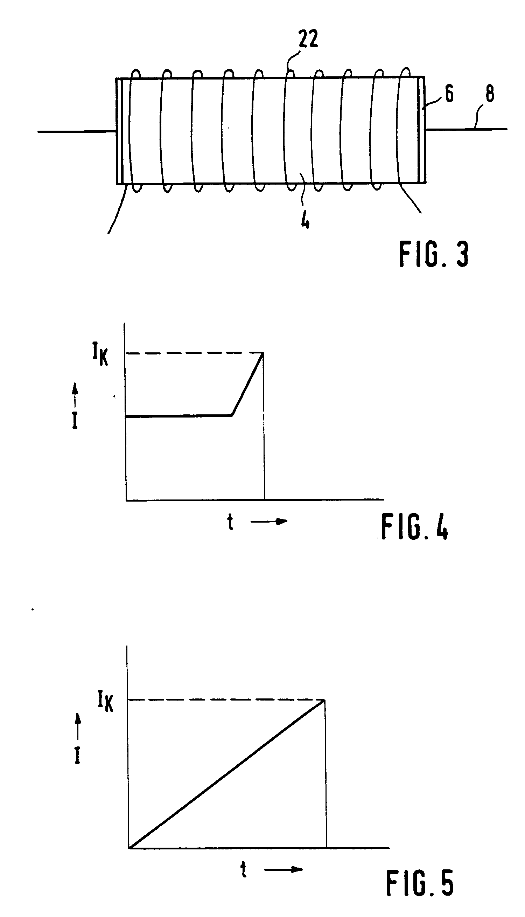

In Fig. 3 ist eine der weiter vorn genannten Möglichkeiten zum Überführen des Supraleitmaterials vom supraleitenden Zustand in den nicht-supraleitenden Zustand, also zum Öffnen des Schalters 2, dargestellt. Es handelt sich um eine um das zylindrische Gehäuse 4 herumgelegte, koaxiale Spule 22. Diese H-Spule oder Magnetspule erzeugt, wenn sie eingeschaltet wird, im Supraleitmaterial 12 ein derart hohes Magnetfeld, daß dort die Supraleitung zusammenbricht und daher der um mehrere Größenordnungen größere "Normalwiderstand" dieses Materials zum Tragen kommt. Die Spule 22 muß nicht koaxial zum Gehäuse 4 angeordnet sein, sondern könnte sich beispielsweise mit ihrer Achse auch rechtwinklig zur Achse des Schalters 2 erstrecken. Wenn der Strom durch die Spule 22 abgeschaltet wird, und demzufolge deren Magnetfeld nicht mehr auf das Supraleitmaterial 12 einwirkt, stellt sich sofort wieder der supraleitende Zustand des Supraleitmaterial 12 ein.

In Fig. 4 ist schematisch dargestellt, wie man durch Aufschalten eines zusätzlichen Stromimpulses auf einen der Stromleiter 8 den durch den Schalter 2 fließenden Strom bis zu einer kritischen Höhe des Stroms Iₖ erhöhen kann, bei dem der supraleitende Zustand des Supraleitmaterials 12 zusammenbricht. Dadurch schaltet der Schalter 2 schlagartig ab.

In Fig. 5 ist alternativ die Möglichkeit schematisch dargestellt, daß durch den Schalter 2 ein zeitlich zunehmender Strom I fließt. Wenn dieser Strom den kritischen Stromwert Iₖ erreicht, schaltet der Schalter 2 schlagartig ab. Das geschilderte Arbeitsspiel beginnt von neuem. Diese Vorgänge können hochfrequent im kHz-Bereich ablaufen.

Auch die zuletzt abgehandelte Möglichkeit soll mit der Begriffsbildung "Einrichtung, mit der das Supraleitmaterial vom supraleitenden Zustand in den nicht-supraleitenden Zustand und umgekehrt überführbar ist" umfaßt sein, da auch das Zuleiten eines derartigen, immer wieder bis zum kritischen Wert Iₖ ansteigenden Stroms zum Schalter 2 eine derartige Einrichtung im weitesten Sinne darstellt.

Bei der zuletzt beschriebenen Art des Schaltens des Schalters 2 hängt die "Erholzeit" bis zum erneuten Abschalten im nächsten Schaltzyklus auch von den thermischen Verhältnissen im Schalter 2 ab. Je besser die Wärmeabfuhr aus den Bereichen des Supraleitmaterials ist, desto kürzer ist die Erholzeit. Man hat also die Möglichkeit, durch die Auslegung der Kühlungsbedingungen oder durch gezielte Veränderung der Kühlungsbedingungen die Schaltfrequenz des Schalters 2 einzustellen.

Es wird ausdrücklich darauf hingewiesen, daß das Supraleitmaterial auch in Form von dünnen Drähten, vorzugsweise mit einem Durchmesser kleiner als 20 µm oder kleiner als 10 µm, vorgesehen sein kann. Vorzugsweise sind Kühlpassagen zwischen den einzelnen Drähten oder zwischen Gruppen supraleitender Drähte vorhanden.

## Patentansprüche

1. Verwendung eines mit Supraleitmaterial (12) als Schaltmedium aufgebauten Hochstromschalters (2) zur Entnahme von Strompulsen aus einer supraleitenden Speicherspule, wobei der Schalter (2) periodisch vom supraleitenden Zustand in den nicht-supraleitenden Zustand überführt wird und umgekehrt,
**dadurch gekennzeichnet,**
daß das Überführen in den nicht-supraleitenden Zustand durch einen am Schalter (2) anstehenden, zeitlich ansteigenden Strom oder durch diesen Strom in Kombination mit einer weiteren Einrichtung (22) zum Überführen in den nicht-supraleitenden Zustand erfolgt.

2. Verwendung nach Anspruch 1, wobei
die Einrichtung eine Magnetfeldquelle (22) aufweist.

3. Verwendung nach Anspruch 1, wobei
die Einrichtung eine Hochfrequenzfeldquelle aufweist.

4. Verwendung nach Anspruch 1, wobei
die Einrichtung eine Laserstrahlquelle aufweist.

5. Verwendung nach Anspruch 1, wobei
die Einrichtung eine Maserstrahlquelle aufweist.

6. Verwendung nach Anspruch 1, wobei
die Einrichtung eine Zusatzstromimpulsquelle aufweist.

7. Verwendung nach einem der Ansprüche 1 bis 6, wobei
das Supraleitmaterial ein Hochtemperatur-Supraleitmaterial ist.

8. Verwendung nach einem der Ansprüche 1 bis 7, wobei
das Supraleitmaterial (12) in Form einer oder mehrere Dünnschichten auf einem oder mehreren zugeordneten Trägern (10) vorgesehen ist.

9. Verwendung Schalter nach Anspruch 8, wobei
mehrere Träger/Dünnschicht-Anordnungen (10, 12) stapelartig aufeinander, vorzugsweise mit dazwischen angeordneten Kühlräumen (14), vorgesehen ist.

10. Verwendung nach Ansprüch 1, wobei
die Einrichtung eine Wärmeenergiestrahlungsquelle ist.

## Claims

1. The use of a high-current switch (2) composed with superconductive material (12) as the switching medium for withdrawing current pulses from a superconducting accumulator coil, with the switch (2) being periodically converted from the superconducting state to the non-superconducting state and vice versa,
characterized in that said conversion to the non-superconducting state is effected by a current present at the switch and increasing with time, or by this current in combination with a further means (22) for conversion to the non-superconducting state.

2. The use according to claim 1,
wherein said means comprises a magnetic field source (22).

3. The use according to claim 1,
wherein said means comprises a radio-frequency field source.

4. The use according to claim 1,
wherein said means comprises a laser beam source.

5. The use according to claim 1,
wherein said means comprises a maser beam source.

6. The use according to claim 1,
wherein said means comprises an additional-current pulse source.

7. The use according to any one of claims 1 to 6,
wherein the superconductive material is a high-temperature superconductive material.

8. The use according to any one of claims 1 to 7,
wherein the superconductive material (12) is provided in the form of one or several thin films on one or several associated carriers (10).

9. The use according to claim 8,
wherein several carrier/thin film arrangements (10, 12) are provided in stacked manner on top of each other, preferably with cooling spaces (14) being disposed therebetween.

10. The use according to claim 1,
wherein said means is a thermal energy radiation source.

## Revendications

1. Utilisation d'un commutateur de courant de haute intensité (2) réalisé à titre de moyen de commutation avec un matériau supra-conducteur (12), pour le prélèvement d'impulsions électriques dans une bobine de stockage supra-conductrice, le commutateur (2) étant passé périodiquement de l'état supra-conducteur à l'état non supra-conducteur et inversement, caractérisé en ce que le passage à l'état non supra-conducteur s'effectue au moyen d'un courant appliqué sur le commutateur (2), augmentant dans le temps, ou au moyen de ce courant, en combinaison avec un dispositif (22) supplémentaire, pour opérer le passage à l'état non supra-conducteur.

2. Utilisation selon la revendication 1, dans laquelle le dispositif présente une source de champ magnétique (22).

3. Utilisation selon la revendication 1, dans laquelle le dispositif présente une source de champ à haute fréquence.

4. Utilisation selon la revendication 1, dans laquelle le dispositif présente une source de rayons laser.

5. Utilisation selon la revendication 1, dans laquelle le dispositif présente une source de rayons maser.

6. Utilisation selon la revendication 1, dans laquelle le dispositif présente une source additionnelle d'impulsions électriques.

7. Utilisation selon l'une des revendications 1 à 6, dans laquelle le matériau supra-conducteur est un matériau supra-conducteur à haute température.

8. Utilisation selon l'une des revendications 1 à 7, dans laquelle le matériau supra-conducteur (12) se présente sous la forme d'une ou plusieurs couches minces, sur un ou plusieurs supports (10) associés.

9. Utilisation selon la revendications 8, dans laquelle plusieurs agencements support/couche mince (10; 12) sont prévus, superposés à la façon d'empilages, de préférence avec des espaces de refroidissement (14) intercalés.

10. Utilisation selon la revendications 1, dans laquelle le dispositif est une source de rayonnement d'énergie thermique.
